# FASCICULE DE BREVET EUROPEEN

(11) **EP 0 759 578 B1**
(45) Date de publication et mention de la délivrance du brevet: **16.02.2000**
(21) Numéro de dépôt: 96401786.7
(22) Date de dépôt: 13.08.1996
(51) Int. Cl.: G03F 7/20, H01J 9/02

(54) **Dispositif d'insolation de zones micrométriques et/ou submicrométriques dans une couche photosensible et procédé de réalisation de motifs dans une telle couche**
Gerät zur Belichtung von Motiven im Mikrometer- und/oder Submikrometerbereich in photoempfindlichen Schichten sowie Verfahren zur Erzeugung von Mustern darin
Apparatus for the exposure of micropattern in a photosensitive layer and process for creating a pattern therein

(30) Priorité: 17.08.1995 FR 9509878
(43) Date de publication de la demande: 26.02.1997
(73) Titulaire: COMMISSARIAT A L'ENERGIE ATOMIQUE, 75015 Paris (FR)
(72) Inventeur: Ida, Michel, 38340 Voreppe (FR); Baptist, Robert, 38560 Jarrie (FR)
(74) Mandataire: Dubois-Chabert, Guy

(56) Documents cités:
- GB-A- 2 253 925
- PATENT ABSTRACTS OF JAPAN vol. 007, no. 030 (P-173), 5 Février 1983 & JP-A-57 181549 (MASATAKE SATOU), 9 Novembre 1982,
- PATENT ABSTRACTS OF JAPAN vol. 007, no. 075 (P-187), 29 Mars 1983 & JP-A-58 004148 (MASATAKE SATOU), 11 Janvier 1983,
- PATENT ABSTRACTS OF JAPAN vol. 016, no. 349 (C-0967), 28 Juillet 1992 & JP-A-04 103779 (HITACHI CABLE LTD), 6 Avril 1992,

## Description

### Domaine technique

La présente invention concerne un procédé de formation de motifs, tels que des trous par exemple, dans une couche de matériau photosensible.

Elle s'applique notamment à la fabrication de sources d'électrons à cathodes émissives à micropointes qui sont utilisées en particulier pour la réalisation de dispositifs de visualisation par cathodoluminescence excitée par émission de champ.

L'invention permet par exemple de fabriquer des écrans plats à micropointes de grande taille, par exemple supérieure à 14 pouces (environ 35 cm), et même des écrans plats à micropointes dont la superficie est voisine de 1 m².

Bien entendu des écrans de taille nettement plus grande peuvent être élaborés grâce à la présente invention.

### Etat de la technique antérieure

Des sources d'électrons à cathodes émissives à micropointes et leurs procédés de fabrication sont décrits par exemple dans les documents (1), (2), (3) et (4) référencés à la fin de la présente description auxquels on peut se reporter.

Pour faciliter la compréhension du problème technique résolu par la présente invention, on décrit ci-après un exemple connu de procédé de fabrication d'une source d'électrons à cathodes émissives à micropointes.

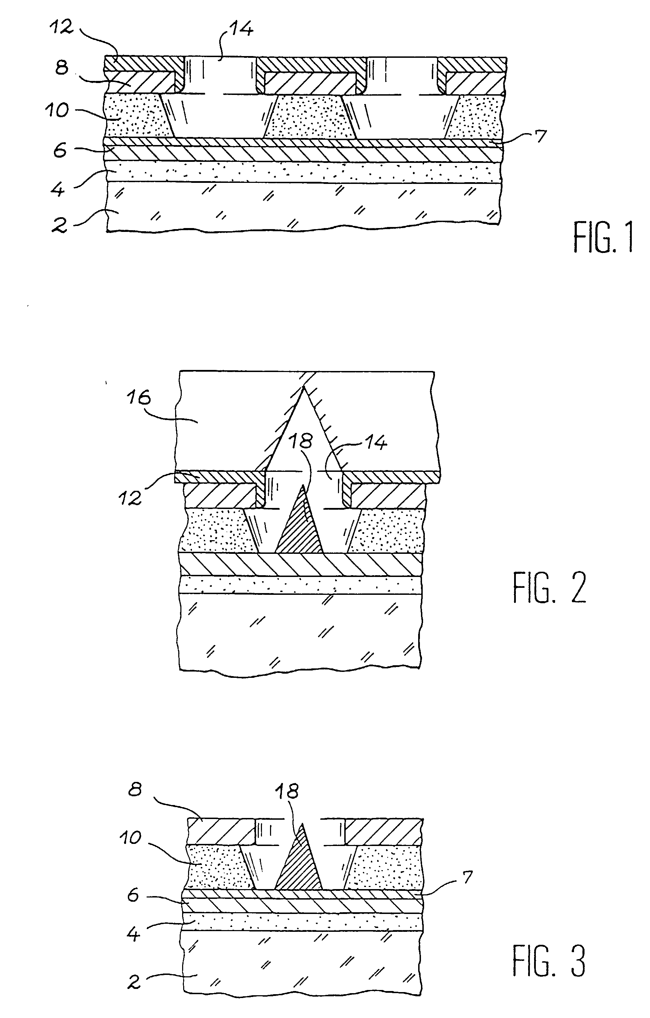

On se référera aux figures 1 à 3 des dessins annexés.

La figure 1 montre une structure déjà élaborée, comprenant, un substrat 2 surmonté d'un isolant 4, un système de conducteurs cathodiques 6, d'une couche résistive 7 et des grilles 8, superposés sous forme croisée, avec un isolant intermédiaire 10, et une couche 12, par exemple en nickel, déposée en surface pour servir de masque lors d'opérations de réalisation de micropointes.

Cette couche 12 de nickel, les grilles 8 et l'isolant 10 sont percés de trous 14, au fond desquels il s'agit de déposer ultérieurement les micropointes constituées d'un métal conducteur en liaison électrique avec les conducteurs cathodiques 6 à travers la couche résistive 7.

La réalisation des micropointes va maintenant être expliquée en faisant référence à la figure 2.

On commence d'abord par effectuer par exemple le dépôt d'une couche en molybdène 16 sur l'ensemble de la structure.

Cette couche 16 présente une épaisseur d'environ 1,8 µm.

Elle est déposée sous incidence normale par rapport à la surface de la structure.

Cette technique de dépôt permet d'obtenir des cônes 18 en molybdène logés dans les trous 14 et ayant une hauteur de 1,2 à 1,5 µm.

Ces cônes constituent les micropointes émettrices d'électrons.

On réalise ensuite la dissolution sélective de la couche de nickel 12 par un procédé électrochimique, de façon à dégager, comme on le voit sur la figure 3, les grilles perforées 8, par exemple en niobium, et à faire apparaître les micropointes 18 émettrices d'électrons.

A quelques variantes technologiques près, la méthode connue ainsi décrite en se référant aux figures 1, 2 et 3 est une de celles qui sont utilisées pour réaliser les micropointes des sources d'électrons à cathodes émissives à micropointes.

Pour que la taille et le positionnement des micropointes 18 soient corrects il faut, bien entendu maîtriser parfaitement la taille des trous réalisés dans les grilles 8 et dans l'isolant 10.

Le problème est donc le suivant :

Il s'agit de réaliser, sur toutes les surfaces devant recevoir des micropointes, des trous dont le diamètre moyen est par exemple de 1,3 µm ou moins.

Les méthodes actuellement utilisées pour réaliser ces trous font appel à des procédés de photolithogravure utilisant la projection directe ou la photorépétition d'un motif élémentaire reproduit sur toutes ces surfaces.

Dans le cas de sources d'électrons de grande taille, supérieure à 14 pouces (environ 35 cm) par exemple, ces procédés deviennent vite très contraignants.

La projection directe nécessite la réalisation d'un masque à l'échelle 1 de grande taille comportant des motifs submicroniques. Ces motifs sont en général composés de métal en couche mince déposé sur un substrat de silice ou de verre.

Ce masque est difficilement réalisable au-dessus de 14 pouces de diagonale avec les techniques classiques utilisées en microélectronique.

En ce qui concerne la photorépétition, on utilise un masque de petite taille, cette taille étant déterminée par la résolution des motifs utilisés.

Pour une résolution de 1 µm, on utilise par exemple un masque de 20 à 50 mm de coté, ce qui oblige à répéter un grand nombre de fois l'opération d'insolation qui est nécessaire à la photolithogravure, pour couvrir la surface totale de la source d'électrons.

Ces deux méthodes (l'une utilisant la projection directe et l'autre la photorépétition) sont donc difficilement applicables à la réalisation de sources d'électrons de grande taille.

La présente invention permet de réaliser un masque pour la formation des trous correspondant aux sources d'électrons, de façon beaucoup plus simple que les procédés connus mentionnés ci-dessus.

Elle concerne aussi un procédé très simple de formation de trous ou d'autres motifs dans une couche de résine photosensible.

L'invention permet de former des trous dont le diamètre peut être de l'ordre de 1µm ou inférieur à 1 µm, sur de petites surfaces ou sur de grandes surfaces.

L'invention permet d'insoler une couche de résine photosensible en des points de celle-ci, qui correspondent aux emplacements des trous à former dans la résine.

Cette résine, une fois développée (c'est-à-dire après dissolution des zones insolées), peut servir de masque pour former des motifs, tels que par exemple, des trous correspondant aux sources d'électrons à micropointes émissives, dans une structure sur laquelle se trouve la couche de résine.

Par exemple, en considérant la structure décrite en faisant référence aux figures 1 à 3, la couche de résine peut servir, après développement, à graver les grilles 8 et l'isolant intermédiaire 10.

De façon plus précise, la présente invention a pour but un procédé de formation d'une monocouche de microbilles sur la surface de la résine, ces microbilles permettant la réalisation de trous dans cette résine photosensible.

Un autre but de la présente invention est de proposer un procédé de réalisation de motifs micrométriques en relief dans une couche de matériau photosensible.

Un but également est de proposer un procédé qui soit de mise en oeuvre simple et qui permette de traiter des substrats présentant une couche photosensible de grande surface.

### Exposé de l'invention

Pour atteindre ces buts, la présente invention a plus précisément pour objet un procédé de réalisation de motifs micrométriques et/ou submicrométriques dans une couche de matériau photosensible disposée sur un substrat. Selon le procédé, on soumet la couche à une atmosphère contenant un liquide non-mouillant du matériau photosensible de manière à réaliser sur celle-ci une monocouche de microgouttelettes du liquide non-mouillant, la couche de matériau photosensible étant maintenue à une température suffisamment basse pour éviter une coalescence des microgouttelettes entre-elles ; on insole la couche de matériau photosensible à travers la monocouche de microgouttelettes pour impressionner sélectivement des zones d'exposition de la couche photosensible avec une lumière d'insolation ; on élimine les microgouttelettes, et on développe la couche de matériau photosensible pour former lesdits motifs selon les zones d'exposition. Le liquide non mouillant utilisé est un liquide transparent à la lumière d'insolation et chaque microgouttelette focalise ainsi la lumière d'insolation dans une desdites zones d'exposition.

Les microgouttelettes formées à la surface de la couche de matériau photosensible sont aussi désignées par le terme "microbilles". Le caractère non-mouillant du liquide par rapport à la couche photosensible permet d'obtenir des microbilles sensiblement sphériques.

On entend par atmosphère contenant un liquide non-mouillant du matériau photosensible soit une atmosphère contenant ledit liquide sous forme de vapeur soit une atmosphère sous la forme d'un "brouillard" comportant, en suspension, des gouttelettes du liquide. A titre d'exemple, dans le cas où le matériau photosensible est une résine et où le liquide non-mouillant est l'eau, l'atmosphère à laquelle est soumise la couche, contient de la vapeur d'eau ou des gouttelettes produites par un pulvérisateur aérosol.

Ainsi, l'atmosphère peut être formée soit par un générateur de vapeur soit par un pulvérisateur du type pneumatique ou à ultrasons, par exemple. De préférence, on peut utiliser un pulvérisateur apte à délivrer des gouttelettes calibrées.

Les motifs que l'on réalise dans la couche de matériau photosensible peuvent correspondre soit aux zones d'exposition, c'est-à-dire les zones atteintes par la lumière d'insolation, mais ils peuvent également correspondre aux zones complémentaires de la couche photosensible, c'est-à-dire les zones qui ne sont pas exposées à la lumière d'insolation. Ceci dépend du choix du matériau photosensible.

Lorsque le matériau photosensible est une résine positive, le développement élimine les zones d'exposition qui ont été insolées. A l'opposé, lorsqu'il s'agit d'une résine négative, le développement élimine le matériau photosensible en dehors des zones d'exposition, en le préservant dans les zones d'exposition.

Le dessin des motifs que l'on souhaite réaliser est déterminé par les microgouttelettes, ou microbilles, formées sur le matériau photosensible. Comme le liquide non-mouillant utilisé est transparent à la (ou aux) longueur(s) d'onde de la lumière d'insolation, chaque microbille forme une lentille qui focalise la lumière dans des zones qui sont les zones dites d'exposition. Ces zones correspondent sensiblement aux zones de contact des microgouttelettes avec la surface du matériau photosensible.

L'expression "zone d'exposition" est alors comprise comme une zone de focalisation où la couche photosensible est soumise à une lumière d'insolation intense par contraste avec des zones qui ne sont soit pas atteintes par la lumière, soit atteintes par la lumière d'insolation directe, c'est-à-dire qui n'a pas été concentrée par une microbille. Ce contraste entre les zones d'exposition fortement isolées et les autres zones permet de former, lors du développement de la couche photosensible, les motifs souhaités.

De préférence, on peut insoler la couche de matériau photosensible avec une lumière d'insolation suffisamment intense pour impressionner le matériau photosensible dans les zones d'exposition dans lesquelles les microgoutelettes focalisent la lumière, et suffisamment faible pour ne pas impressionner le matériau photosensible en dehors des zones d'exposition.

Une application importante de l'invention est la réalisation de trous dans une couche de résine photosensible positive servant de masque pour la fabrication d'une source d'électrons.

Ainsi, l'invention concerne aussi un procédé de fabrication d'une source d'électrons à cathodes émissives à micropointes selon lequel :
- on forme une structure comprenant des conducteurs cathodiques sur un substrat, une couche électriquement isolante sur ces conducteurs cathodiques, et, sur cette couche électriquement isolante, des grilles qui font un angle avec les conducteurs cathodiques,
- dans des domaines où les grilles croisent les conducteurs cathodiques, on forme des trous à travers les grilles et la couche isolante, et
- on forme des micropointes en matériau émetteur d'électrons dans ces trous, sur les conducteurs cathodiques,
ce procédé étant caractérisé en ce que ces trous sont obtenus en formant une couche de résine photosensible positive au moins dans lesdits domaines, à la surface de la structure, en formant des trous dans la couche de résine conformément au procédé décrit ci-dessus et en gravant les grilles et la couche isolante à travers ces trous formés dans la couche de résine.

L'invention concerne aussi un écran plat d'affichage utilisant la source d'électrons obtenue par ce procédé.

L'invention concerne enfin un dispositif pour la mise en oeuvre du procédé, c'est-à-dire pour l'insolation de zones micrométriques d'une couche de matériau photosensible disposés sur un substrat. Ce dispositif comporte un générateur d'une atmosphère contenant un liquide non-mouillant du matériau photosensible, une source de lumière d'insolation, et un système de support du substrat comportant la couche de matériau photosensible, apte à contrôler la température de ce substrat et à maintenir successivement la couche photosensible en regard dudit générateur et de la source de lumière.

Selon un aspect particulier, le système de support peut comporter un porte-substrat apte à refroidir le substrat et des moyens de fixation du substrat sur le porte substrat pour exposer la couche de matériau photosensible.

D'autres caractéristiques et avantages de la présente invention ressortiront mieux de la description qui va suivre, donnée à titre purement illustratif et non limitatif, en référence aux figures annexées.

### Brève description des figures

- les figures 1 à 3, déjà décrites, sont des coupes schématiques partielles illustrant un procédé connu de fabrication d'une source d'électrons à cathodes émissives à micropointes,
- la figure 4 est une coupe schématique d'un substrat de source d'électrons et montre l'insolation de zones d'exposition d'une couche de résine superficielle conformément à l'invention,
- la figure 5 est une représentation schématique d'un système de support de substrat pour le traitement d'une couche de matériau photosensible conformément à l'invention,
- la figure 6 montre de façon schématique un pulvérisateur à ultrasons et illustre la formation d'une monocouche de microgouttelettes sur la couche de matériau photosensible, conformément à l'invention,
- la figure 7 montre de façon schématique une étape d'insolation de la couche de matériau photosensible à travers la monocouche de microgouttelettes à l'aide d'une source de lumière.

### Description détaillée de modes de mise en oeuvre de l'invention

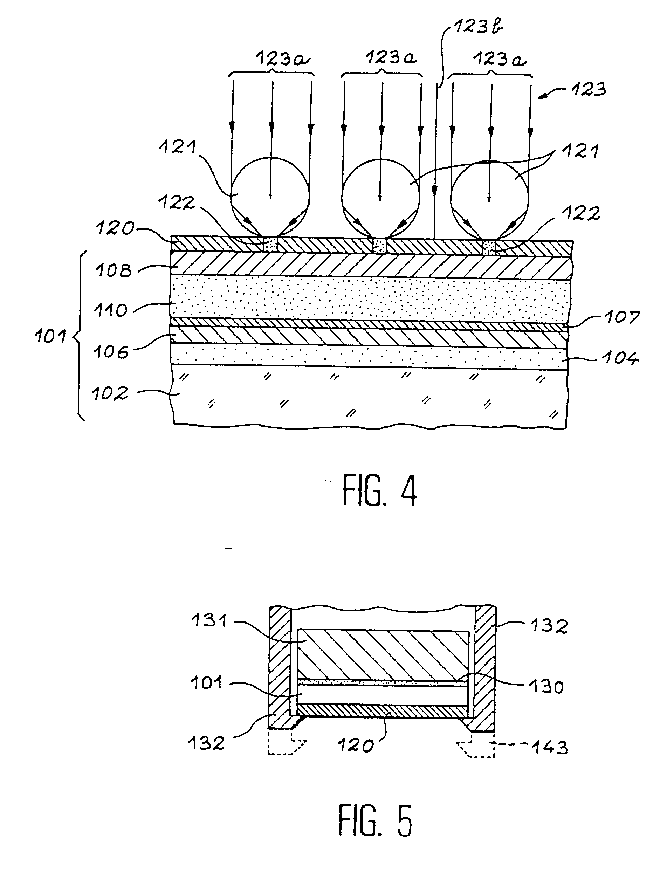

La figure 4 montre de façon schématique la fonction de focalisation de microgouttelettes déposées à la surface d'une couche de matériau photosensible pour insoler sélectivement certaines parties de celles-ci. L'exemple de la figure 4 concerne la formation de trous dans une couche de résine photosensible positive. La couche de résine (120) sert alors elle-même de masque pour la formation de trous dans les couches sous-jacentes (108,110) pour la réalisation d'une structure conforme à la figure 1 déjà décrite. Sur la figure 4, pour des raisons de simplification, des références identiques auxquelles on a ajouté 100, sont utilisées pour des parties identiques ou similaires à des parties de la figure 1.

L'empilement 101 illustré à la figure 4 comporte ainsi un substrat 102 surmonté dans l'ordre d'une couche électriquement isolante 104, un système de conducteurs électriques cathodiques 106, une couche résistive 107, une couche intermédiaire 110 électriquement isolante, et des grilles 108 superposées, sous forme croisée.

On souhaite former à la surface de l'empilement 101, c'est-à-dire au-dessus des grilles 108 un masque de gravure avec des ouvertures correspondant à des trous que l'on veut pratiquer dans les couches 108 et 110. Ces trous correspondent aux trous 14 de la figure 1.

On forme ainsi sur l'empilement 101 une couche 102 de matériau photosensible, en l'occurrence une résine photosensible positive. Des ouvertures sont pratiquées dans cette couche de résine conformément à la présente invention.

En soumettant la couche de résine 120 à une atmosphère chargée de vapeur d'eau, ou à une atmosphère comprenant un brouillard aérosol et en refroidissant la couche 120, on forme à sa surface des microgouttelettes 121. Le refroidissement de la couche 120 a un rôle double de condensation des gouttelettes et d'empêcher la coalescence de celles-ci. A titre d'exemple pour une couche de résine sur laquelle on formé des microgouttelettes d'eau, il convient de refroidir la couche 120 à une température préférentiellement comprise entre - 5 et + 5°C.

Lorsque les microgouttelettes 121 sont formées, on expose la couche 120 photosensible à une lumière parallèle d'insolation représentée avec la référence 123.

Dans l'exemple de la figure 4 les microgouttelettes 121 d'eau sont transparentes aux longueurs d'onde de la lumière d'insolation. Les microgouttelettes 121, ou microbilles focalisent et donc concentrent les rayons de lumière 123a qui les atteignent en des zones 122, dites zones d'exposition, dans lesquelles la couche photosensible 120 est impressionnée.

L'intensité de la lumière d'insolation ou le temps d'exposition est choisi de sorte que les rayons de lumière 123b qui atteignent directement la couche 120 ne l'impressionnent pas.

Après l'élimination des microgouttelettes 121, on développe la couche 120 pour former des motifs selon les zones d'exposition. Dans le cas du présent exemple, le développement permet d'éliminer (dissoudre) le matériau de la couche dans les zones 122 de façon à y pratiquer des ouvertures. La couche 120 forme finalement un masque pour la gravure de cavités dans les couches 108 et 110 conformément à des procédés connus.

Les motifs que l'on réalise ne sont pas nécessairement des trous mais peuvent aussi être des microreliefs.

A titre d'exemple, si on remplace la couche de résine positive par une couche de résine négative, on obtient dans le cadre de l'exemple de la figure 4 des microcylindres en relief à la place des trous. Le matériau photosensible est alors éliminé dans toutes les régions qui ne comportaient pas de microgouttelettes lors de l'insolation.

Les figures 5 à 7 montrent de façon plus précise un dispositif destiné à la mise en oeuvre notamment des opérations de formation de microbilles et d'insolation, conformément à l'invention.

Comme le montre la figure 5, l'ensemble formé par l'empilement 101 et une couche photosensible 120 est maintenu par un système de support. Ce système de support comporte un porte-substrat 131 contre lequel est appliqué par sa face représentée par le substrat 102, l'empilement 101 recouvert d'une couche de résine photosensible 120 déposée sur son autre face représentée par la couche métallique 108, au moyen de griffes 132. Les griffes 132 peuvent être déplacées d'une position 143 représentée en trait discontinu, dans laquelle l'empilement 101 et la couche 120 peuvent être libérés ou insérés sur le système de support, à une position représentée en trait plein dans laquelle les griffes servent au maintien de l'empilement 101 recouvert par la couche 120.

Un disque 130, par exemple en un élastomère bon conducteur thermique, est avantageusement disposé entre le porte-substrat 131 et le substrat 102 de l'empilement 101 pour faciliter et uniformiser les échanges thermiques entre ces parties.

Le porte-substrat a en effet la fonction de refroidir le substrat 101, et partant, la couche de résine 120, afin de la porter à une température convenable pour la formation de microgouttelettes.

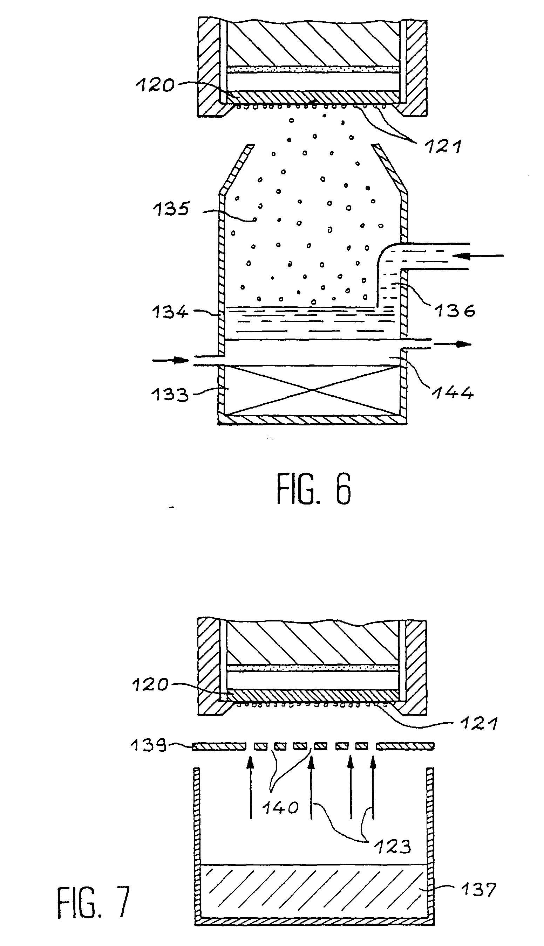

Après l'installation du substrat sur le système de support et après son refroidissement, l'ensemble est transféré au-dessus d'un générateur de brouillard. La figure 6 représente de façon schématique un tel générateur. Il s'agit d'un générateur ultrasonique de type Spray Pyrosol. Toutefois, il est possible de remplacer ce générateur par tout type de générateur aérosol, de brouillard, de vapeur ou de microgouttelettes qui permet de former des microgouttelettes sur la surface de la couche de résine 120.

Le générateur de brouillard représenté à la figure 6 comporte une cuve 134 contenant le liquide non mouillant utilisé pour la formation des microgouttelettes. Le niveau du liquide dans la cuve 134 est maintenu sensiblement constant par une arrivée de liquide 136.

Un générateur d'ultrasons 135 placé sous la cuve 134 est prévu pour transmettre au liquide des ultrasons afin de former des microgouttelettes 135 calibrées, en spray. Le couplage ultrasonique entre le générateur d'ultrasons 133 et la cuve 134 se fait à travers un transducteur 144, refroidi par eau pour stabiliser les conditions de fonctionnement.

Pour obtenir des microgouttelettes avec une taille souhaitée, correspondant à une application particulière, il convient d'ajuster différents paramètres du générateur, tels que la puissance, la fréquence, un débit de gaz dans le générateur, le débit de liquide et sa température. On peut ainsi obtenir des microgouttelettes avec une taille de 0,5 à 7 pm par exemple. Dans un souci de simplification de la figure des détails et pièces du générateur, tels qu'une amenée d'air ou de gaz, ne sont pas représentés.

A titre d'exemple, pour un appareil du commerce, avec une fréquence de fonctionnement de 1 MHz, on obtient des gouttelettes d'une taille de l'ordre de 3 à 4 µm.

Il est possible de se reporter au sujet de la pulvérisation par ultrasons aux documents (5) et (6) référencés à la fin de la présente description.

Comme le montre aussi la figure 6, le substrat 101 équipé de la couche photosensible 120 est maintenu avantageusement au-dessus de la cuve 134 jusqu'à ce qu'une couche de microgouttelettes se forme à la surface de la couche 120.

La position relative de la cuve et du substrat représentée à la figure 6 permet de tourner la couche 120 vers le bas et d'orienter l'ouverture de la cuve 134 vers le haut. Cette disposition n'est pas indispensable mais permet d'éviter que de grosses gouttes indésirables de liquide se déposent sur la couche photosensible.

La figure 7 se rapporte à l'étape d'insolation du procédé de l'invention. Le substrat 101, équipé de la couche 120 est déplacé vers une source 137 de lumière parallèle. La couche 120 est alors soumise à la lumière 123 de la source à travers la monocouche de gouttelettes 121. Le choix d'un liquide non mouillant transparent à la longueur d'onde de la lumière permet, comme expliqué ci-dessus, d'impressionner sélectivement certaines zones de la couche photosensible 120.

Un masque 139 peut être disposé entre la source de lumière 137 et la monocouche de microgouttelettes 121. Ainsi, il est possible d'insoler sélectivement certaines régions seulement de la couche 120 qui correspondent à des ouvertures 140 du masque 139. Il est possible par exemple dans le cas de l'exemple illustré à la figure 4 de réserver des régions dans lesquelles ne sont pas formés des trous.

La réalisation des étapes du procédé des figures 5 à 7 sont réalisées, selon les applications, sous atmosphère à humidité, température et empoussièrement contrôlés pour éviter tout effet parasite du procédé.

Le transfert du substrat par le système de support devant le générateur de brouillard puis devant la source de lumière peut être effectué soit en défilement continu soit avec un arrêt devant ces appareils.

De plus, après l'insolation, l'ensemble du substrat 101 recouvert de la couche 120 est transféré à un poste de déchargement, non représenté, où les microgouttelettes sont éliminées avec un solvant ou par évaporation. La couche photosensible 120 est ensuite développée, pour dissoudre, par exemple, des régions impressionnées, et ainsi former les motifs tels que des trous ou des reliefs.

Finalement, grâce à l'invention, il est possible de réaliser de façon simple et sur de grandes surfaces des trous ou reliefs micrométriques.

La réalisation de microtrous peut être utilisée dans la fabrication de sources d'électrons d'écrans à micropointes comme indiqué ci-dessus, mais aussi à la fabrication de dispositif tels que des réseaux à trous ou des membranes microperforées.

La réalisation de microreliefs peut être utilisée par exemple dans des systèmes antireflets ou la fabrication de matrices de microcylindres.

### DOCUMENTS CITES DANS LA PRESENTE DESCRIPTION

*(****1****)*
   FR-A-2 593 953 (voir aussi EP-A-0 234 989)
*(****2****)*
   US-A-4 857 161
*(****3****)*
   FR-A-2 663 462
*(****4****)*
   FR-A-2 687 839 (voir aussi EP-A-0 558 393)
*(****5****)*
   "Pulvérisation par ultrasons appliquée à la spectrométrie d'absorption atomique" de J. SPITZ et G. UNY - Applied Optics, vol. 7, N°7, JUILLET 1968.
*(****6****)*
   "Chemical vapor deposition at low temperatures" de J.C. VIGUIE et K. SPITZ - Journal of the Electrochemical Society, vol. 122, N°4, AVRIL 1975.

## Revendications

1. Procédé de réalisation de motifs micrométriques et/ou submicrométriques dans une couche (120) de matériau photosensible disposée sur un substrat (101),
caractérisé en ce que
- on soumet la couche à une atmosphère contenant un liquide non-mouillant du matériau photosensible de manière à réaliser sur celle-ci une monocouche de microgouttelettes (121) du liquide non-mouillant, la couche de matériau photosensible (120) étant maintenue à une température suffisamment basse pour éviter une coalescence des microgouttelettes (121) entre-elles,
- on insole la couche de matériau photosensible à travers la monocouche de microgouttelettes (121) pour impressionner sélectivement des zones d'exposition (122) de la couche photosensible (120) avec une lumière d'insolation (123),
- on élimine les microgouttelettes (121),
- on développe la couche de matériau photosensible pour former lesdits motifs selon les zones d'exposition,
et dans lequel on utilise un liquide non mouillant, transparent à la lumière d'insolation, chaque microgouttelette focalisant la lumière (123) dans une desdites zones d'exposition (122).

2. Procédé selon la revendication 1, caractérisé en ce qu'on insole la couche de matériau photosensible avec une lumière d'insolation suffisamment intense pour impressionner le matériau photosensible dans les zones d'exposition (122) dans lesquelles les microgouttelettes (121) focalisent ladite lumière, et suffisamment faible pour ne pas impressionner le matériau photosensible en dehors des zones d'exposition (122).

3. Procédé selon la revendication 1, caractérisé en ce que la couche de matériau photosensible (120) est une résine positive.

4. Procédé selon la revendication 3, caractérisé en ce que lors du développement on élimine le matériau photosensible dans les zones d'exposition (122).

5. Procédé selon la revendication 1, caractérisé en ce que la couche de matériau photosensible est une résine négative.

6. Procédé selon la revendication 5, caractérisé en ce que lors du développement on élimine le matériau photosensible en dehors des zones d'exposition (122) en préservant le matériau dans les zones d'exposition (122).

7. Procédé selon la revendication 1, caractérisé en ce que le liquide non-mouillant est de l'eau.

8. Procédé selon la revendication 1, caractérisé en ce qu'on forme l'atmosphère contenant le liquide non-mouillant avec un pulvérisateur apte à former des microgouttelettes calibrées.

9. Procédé selon la revendication 8, caractérisé en ce qu'on utilise un pulvérisateur à ultrasons.

10. Procédé selon la revendication 8, caractérisé en ce qu'on utilise un pulvérisateur pneumatique.

11. Procédé selon la revendication 1, caractérisé en ce qu'on forme l'atmosphère contenant le liquide non-mouillant avec un générateur de vapeur du liquide.

12. Procédé selon la revendication 1, caractérisé en ce qu'on insole la couche de matériau photosensible (120) à travers un masque (139) disposé entre une source (137) de rayonnement d'insolation et la monocouche de microgouttelettes (121), ce masque présentant des ouvertures (140) correspondant à des régions de la couche de matériau photosensible que l'on souhaite insoler.

13. Procédé selon la revendication 1, caractérisé en ce que les motifs micrométriques sont des ouvertures traversant la couche de matériau photosensible (120).

14. Procédé de fabrication d'une source d'électrons à cathodes émissives à micropointes selon lequel :
- on forme une structure comprenant des conducteurs cathodiques (106) sur un substrat (102), une couche électriquement isolante (110) sur ces conducteurs cathodiques, et, sur cette couche électriquement isolante, des grilles (108) qui font un angle avec les conducteurs cathodiques,
- dans des domaines où les grilles (108) croisent les conducteurs cathodiques (106), on forme des trous à travers les grilles et la couche isolante (110), et
- on forme des micropointes en matériau émetteur d'électrons dans ces trous, sur les conducteurs cathodiques,
ce procédé étant caractérisé en ce que ces trous sont obtenus en formant une couche de résine photosensible positive au moins dans lesdits domaines, à la surface de la structure, en formant des ouvertures dans la couche de résine conformément au procédé selon la revendication 1 et en gravant les grilles et la couche isolante à travers ces ouvertures formés dans la couche de résine.

15. Dispositif d'insolation de zones micrométriques d'une couche (120) de matériau photosensible disposée sur un empilement (101), caractérisé en ce qu'il comporte un générateur (133, 134, 136, 144) d'une atmosphère (135) contenant un liquide non-mouillant du matériau photosensible, une source (137) de lumière d'insolation, et un système de support (131, 132) de l'empilement (101) comportant la couche de matériau photosensible (120), apte à contrôler la température de la couche de matériau photosensible de façon à la maintenir suffisamment basse pour former sur le matériau photosensible une monocouche de microgouttelettes du liquide non mouillant et éviter une coalescence des microgouttelettes, et apte à maintenir successivement la couche de matériau photosensible en regard dudit générateur et de la source de lumière.

16. Dispositif selon la revendication 15, caractérisé en ce que le générateur d'une atmosphère contenant le liquide non-mouillant est un appareil choisi parmi un pulvérisateur pneumatique de microgouttelettes, un pulvérisateur de microgouttelettes à ultrasons, ou un générateur de vapeur dudit liquide.

17. Dispositif selon la revendication 15, caractérisé en ce que la source de lumière (137) est une source de lumière parallèle.

18. Dispositif selon la revendication 15, caractérisé en ce que le système de support (131, 132) comporte un porte-substrat (131) apte à refroidir l'empilement (101) et des moyens de fixation (132) du substrat sur le porte substrat pour exposer la couche de matériau photosensible.

19. Dispositif selon la revendication 15, caractérisé en ce que le système de support comporte une plaque (130) d'élastomère conducteur thermique disposée entre l'empilement (101) et le porte-substrat (131) pour faciliter et uniformiser des échanges thermiques entre le substrat et le porte-substrat.

## Patentansprüche

1. Verfahren zur Erzeugung von mikrometrischen und/oder submikrometrischen Mustern in einer Schicht (120) aus lichtempfindlichem Material, gebildet auf einem Substrat (101), **dadurch gekennzeichnet**,
- dass man die Schicht einer Atmosphäre aussetzt, die eine das lichtempfindliche Material nicht netzende Flüssigkeit enthält, um auf dieser Schicht eine Monoschicht aus Mikrotröpfchen (121) der nicht-netzenden Flüssigkeit zu realisieren, wobei die Schicht aus lichtempfindlichem Material (120) auf einer ausreichend niedrigen Temperatur gehalten wird, um eine Koaleszenz der Mikrotröpfchen (121) miteinander zu verhindern,
- dass man die Schicht aus lichtempfindlichem Material durch die Mikrotröpfchen (121) hindurch bestrahlt, um selektiv Belichtungszonen (122) der lichtempfindlichen Schicht (120) mit einem Bestrahlungslicht (123) zu belichten,
- dass man die Mikrotröpfchen (121) eliminiert,
- dass man die Schicht aus lichtempfindlichem Material entwickelt, um in den Belichtungszonen die genannten Muster zu bilden.

2. Verfahren nach Anspruch 1, dadurch gekennzeichnet, dass man die Schicht aus lichtempfindlichem Material mit einem Bestrahlungslicht bestrahlt, das ausreichend stark ist, um das lichtempfindliche Material in den Belichtungzonen (122) zu belichten, in die die Mikrotröpfchen (121) das genannte Licht fokussieren, und ausreichend schwach, sodass es das lichtempfindliche Material außerhalb der Belichtungszonen (122) nicht belichtet.

3. Verfahren nach Anspruch 1, dadurch gekennzeichnet, dass die Schicht aus lichtempfindlichem Material (120) ein Positivresist ist.

4. Verfahren nach Anspruch 3, dadurch gekennzeichnet, dass man bei der Entwicklung das lichtempfindliche Material in den Belichtungszonen (122) eliminiert.

5. Verfahren nach Anspruch 1, dadurch gekennzeichnet, dass die Schicht aus lichtempfindlichem Material ein Negativresist ist.

6. Verfahren nach Anspruch 5, dadurch gekennzeichnet, dass man bei der Entwicklung das lichtempfindliche Material außerhalb der Belichtungszonen (122) eliminiert und das Material dabei in den Belichtungszonen (122) präserviert.

7. Verfahren nach Anspruch 1, dadurch gekennzeichnet, dass die nicht-netzende Flüssigkeit Wasser ist.

8. Verfahren nach Anspruch 1, dadurch gekennzeichnet, dass man die die nicht-netzende Flüssigkeit enthaltende Atmosphäre mit einem Zerstäuber erzeugt, der fähig ist, kalibrierte Tröpfchen zu bilden.

9. Verfahren nach Anspruch 8, dadurch gekennzeichnet, dass man einen Ultraschall-Zerstäuber benutzt.

10. Verfahren nach Anspruch 8, dadurch gekennzeichnet, dass man einen pneumatischen Zerstäuber benutzt.

11. Verfahren nach Anspruch 1, dadurch gekennzeichnet, dass man die die nicht-netzende Flüssigkeit enthaltende Atmosphäre mit einem Dampferzeuger der Flüssigkeit bildet.

12. Verfahren nach Anspruch 1, dadurch gekennzeichnet, dass man die Schicht aus lichtempfindlichem Material (120) durch eine Maske (139) bestrahlt, angeordnet zwischen einer Bestrahlungsquelle (137) und der Monoschicht aus Mikrotröpfchen (121), wobei diese Maske Öffnungen (140) aufweist, die Bereichen der Schicht aus lichtempfindlichem Material entsprechen, die man bestrahlen möchte.

13. Verfahren nach Anspruch 1, dadurch gekennzeichnet, dass die mikrometrischen Muster Öffnungen sind, die die Schicht aus lichtempfindlichem Material (120) durchqueren.

14. Herstellungsverfahren einer Elektronenquelle mit Mikrospitzen-Emissiönskathoden mit folgenden Schritten:
- Bilden einer Struktur mit Kathodenleitern (106) auf einem Substrat (102), einer elektrisch isolierenden Schicht (110) auf diesen Kathodenleitern und von Gittern (108) auf dieser elektrisch isolierenden Schicht, die mit den Kathodenleitern einen Winkel bilden,
- Bilden von Löchern in Bereichen, wo die Gitter (108) die Kathodenleiter (106) kreuzen, durch die Gitter und die Isolierschicht (110) hindurch, und
- Bilden von Mikrospitzen aus elektronenemittierendem Material in diesen Löchern, auf den Kathodenleitern,
**dadurch gekennzeichnet**,
dass diese Löcher hergestellt werden durch das Bilden einer lichtempfindlichen Schicht aus Positvresist in wenigstens den genannten Bereichen an der Oberfläche der Struktur, indem gemäß dem Verfahren nach Anspruch 1 Löcher in der Resistschicht gebildet werden und die Gitter und die Isolierschicht durch diese in der Restistschicht gebildeten Löcher hindurch geätzt werden.

15. Bestrahlungsvorrichtung der mikrometrischen Zonen einer Schicht (120) aus lichtempfindlichem Material, gebildet auf einem Stapel (101),
**dadurch gekennzeichnet**,
dass sie einen Erzeuger (133, 134, 136, 144) einer das lichtempfindliche Material nicht netzenden Flüssigkeit enthaltenden Atmosphäre (135), eine Bestrahlungslichtquelle (137) und ein Trägersystem (131, 132) des Stapels (101) umfaßt, der die Schicht aus lichtempfindlchem Material (120) enthält, fähig die Temperatur der Schicht aus lichtempfindlichem Material so zu kontrollieren, dass sie ausreichend niedrig bleibt, um auf dem lichtempfindlichen Material eine Monoschicht aus Mikrotröpfchen der nicht-netzenden Flüssigkeit zu bilden und eine Koaleszenz der Mikrotröpfchen zu verhindern, und fähig, die Schicht aus lichtempfindlichem Material dem genannten Erzeuger und der Lichtquelle nacheinander gegenüberzuhalten.

16. Vorrichtung nach Anspruch 15, dadurch gekennzeichnet, dass der Erzeuger einer die nicht-netzende Flüssigkeit enthaltenden Atmosphäre ein Gerät ist, das ausgewählt wird unter einem pneumatischen Mikrotröpfchenzerstäuber, einem Ultraschall-Mikrotröpfchen-Zerstäuber oder einem Dampferzeuger der genannten Flüssigkeit.

17. Vorrichtung nach Anspruch 15, dadurch gekennzeichnet, dass die Lichtquelle (137) eine Parallelllichtquelle ist.

18. Vorrichtung nach Anspruch 15, dadurch gekennzeichnet, dass das Trägersystem (131, 132) einen Substratträger (131) umfaßt, fähig den Stapel (101) zu kühlen, und Einrichtungen (132) zum Befestigen des Substrats auf dem Substratträger, um die Schicht aus lichtempfindlichen Material zu belichten.

19. Vorrichtung nach Anspruch 15, dadurch gekennzeichnet, dass das Trägersystem eine Platte (130) aus wärmeleitfähigem Elastomer umfaßt, angeordnet zwischen dem Stapel (101) und dem Substratträger (131), um Wärmeaustausche zwischen dem Substrat und dem Substratträger zu erleichtern und gleichmäßig zu machen.

## Claims

1. Method of producing micrometric and/or submicrometric patterns in a layer (120) of photosensitive material positioned on a substrate (101),
characterized in that
- the layer is subjected to an atmosphere containing a liquid that does not wet the photosensitive material in a manner that produces a monolayer of microdroplets (121) of the non-wetting liquid on this layer, the photosensitive material layer (120) being kept at a temperature sufficiently low to prevent the coalescence of the micro-droplets (121) with one another,
- the layer of photosensitive material is insolated through the monolayer of micro-droplets (121) in order to selectively print the areas of exposure (122) of the photosensitive layer (120) with an insolation light (123),
- the micro-droplets (121) are removed,
- the layer of photosensitive material is developed in order to form said patterns in accordance with the areas of exposure,
and in which a non-wetting liquid is used which is transparent to the insolation light (123), each micro-droplet focussing the light in said areas of exposure (122).

2. Method according to claim 1, characterized in that the layer of photosensitive material is insolated with insolation light sufficiently intense to print the photosensitive material in the areas of exposure (122) in which the micro-droplets (121) focus said light, and sufficiently weak to not print the photosensitive material outside the areas of exposure (122).

3. Method according to claim 1, characterized in that the layer (120) of photosensitive material is a positive resin.

4. Method according to claim 3, characterized in that during development the photosensitive material is removed from the areas of exposure (122).

5. Method according to claim 1, characterized in that the layer of photosensitive material is a negative resin.

6. Method according to claim 5, characterized in that during development the photosensitive material is removed outside the areas of exposure (122) while retaining the material in the areas of exposure.

7. Method according to claim 1, characterized in that the non-wetting liquid is water.

8. Method according to claim 1, characterized in that the atmosphere containing the non-wetting liquid is formed with an atomizer capable of forming graded micro-droplets.

9. Method according to claim 8, characterized in that an ultrasonic atom izer is used.

10. Method according to claim 8, characterized in that a pneumatic atomizer is used.

11. Method according to claim 1, characterized in that the atmosphere containing the non-wetting liquid is formed with a generator of vapour from the liquid.

12. Method according to claim 1, characterized in that the layer (120) of photosensitive material is insolated through a mask (139) positioned between a source (137) of insolation radiation and the monolayer of micro-droplets (121), this mask having openings (140) corresponding to the regions of the layer of photosensitive material that one wishes to insolate.

13. Method according to claim 1, characterized in that the micron size patterns are openings going through the layer of photosensitive material (120).

14. Method of manufacturing a micro-point cathode electron source in accordance with which:
- a structure including cathode conductors (106) is formed on a substrate (102), an electrically insulating layer (110) is formed on the cathodic conductors, and, grids (108) are formed on the electrically insulating layer which make an angle with the cathodic conductors,
- holes are formed through the grids (108) and the insulating layer (110) in areas where the grids cross the cathodic conductors (106),
- micro-points of electron emitting material are formed in these holes, on the cathodic conductors,
this method being characterized in that these holes are obtained by forming a layer of positive photosensitive resin at least in said areas, at the surface of the structure, by forming openings in the layer of resin in accordance with the method according to claim 1 and by etching the grids and the insulating layer through these openings formed in the resin layer.

15. Device for insolating the micrometric areas of a layer (120) of photosensitive material arranged on a stack (101), characterized in that it comprises an atmosphere (135) generator (133, 134, 136, 144) containing a liquid which does not wet the photosensitive material, a source (137) of insolation light, and a support system (131, 132) for the stack (101) including the layer (120) of photosensitive material able to control the temperature of the photosensitive material layer in such a way as to keep it sufficiently low to form on the photosensitive material a monolayer of micro-droplets of the non-wetting liquid and prevent a coalescence of the micro-droplets, and able to successively maintain the photosensitive material layer in front of said generator and the light source.

16. Device according to claim 15, characterized in that the atmosphere generator containing the non-wetting liquid is an apparatus chosen from a pneumatic micro-droplet atomizer, an ultrasonic micro-droplet atomizer or a generator of vapour from said liquid.

17. Device according to claim 15, characterized in that the light source (137) is a source of parallel light.

18. Device according to claim 15, characterized in that the support system (131, 132) comprises a substrate carrier (131) capable of cooling the stack (101) and means (132) of fixing the substrate onto the substrate carrier in order to expose the layer of photosensitive material.

19. Device according to claim 15, characterized in that the support system includes a plate (130) of thermally conductive elastomer positioned between the stack (101) and the substrate carrier (131) in order to facilitate and make uniform the thermal exchange between the substrate and the substrate carrier.
